# DEMANDE DE BREVET EUROPEEN

(11) **EP 0 818 685 A1**
(43) Date de publication de la demande: **14.01.1998**
(21) Numéro de dépôt: 97401538.0
(22) Date de dépôt: 01.07.1997
(51) Int. Cl.: G01R 31/28, G01R 1/04

(54) **Dispositif de test de cartes électroniques dans des conditions spéciales de température ou de traitement**

(30) Priorité: 08.07.1996 FR 9608475
(71) Demandeur: DASSAULT ELECTRONIQUE, F-92214 Saint-Cloud (FR)
(72) Inventeur: Naffrechoux, Jean-Pierre, 78120 Clairefontaine En Yvelines (FR)
(74) Mandataire: Nicolle, Olivier

(57) **Abrégé**

Le bus (2) comprend des première et seconde parties (5 et 7) fonctionnant selon des mêmes conditions électriques. La première partie (5) du bus est d'une longueur choisie, et apte à être insérée dans une enceinte de test (8, 10) afin de soumettre des cartes électroniques connectées sur cette première partie (5) du bus à des conditions de température ou de traitement, tandis que la seconde partie (7) du bus est située hors de l'enceinte et à côté de celle-ci, pour soumettre des cartes électroniques connectées sur cette seconde partie du bus (5) à d'autres conditions de température ou de traitement, mais dans les mêmes conditions électriques de fonctionnement.

## Description

La présente invention concerne un dispositif de test de cartes électroniques dans des conditions spéciales de température ou de traitement.

On connaît déjà des dispositifs de test comprenant une enceinte dans laquelle sont logées des cartes électroniques à tester pour les soumettre à des conditions spéciales de température ou de traitement.

Le plus souvent, les dispositifs électroniques d'instrumentation ou de test ne sont pas aptes à supporter des conditions spéciales, par exemple des températures allant de -55°C à +125°C ou des traitements chimiques spéciaux ou analogues.

Dans ces conditions, ils sont disposés hors de l'enceinte pour ne pas être endommagés par ces conditions spéciales.

Le test en fonctionnement électrique est réalisé alors avec des cartes électroniques à tester reliées au dispositif d'instrumentation ou de mesure par des câbles, des cordons prolongateurs ou analogues qui traversent l'enceinte pour transmettre les signaux électriques de fonctionnement des dispositifs d'instrumentation vers les cartes à tester et réciproquement.

Ce genre de test n'est pas totalement satisfaisant lorsque notamment les signaux électriques ainsi véhiculés par les câbles ou cordons sont à fréquence ou vitesse élevée. En effet, la longueur des câbles ou des cordons empêche alors aux cartes à tester de fonctionner aux mêmes conditions électriques que celles des dispositifs d'instrumentation et de mesure. Il en résulte un décalage temporel de la transmission des signaux électriques de fonctionnement qui n'est pas négligeable et qui peut ainsi perturber la qualité du test.

La présente invention apporte une solution à ce problème.

Elle porte sur un dispositif de test de cartes électroniques dans des conditions de température ou de traitement choisies, lesdites cartes électroniques étant aptes à être connectées sur un bus électronique supportant des lignes électriques pour la transmission de signaux de fonctionnement entre lesdites cartes électroniques.

Selon une définition générale de l'invention, le bus comprend des première et seconde parties fonctionnant selon les mêmes conditions électriques, la première partie du bus étant de longueur choisie, et apte à être insérée dans une enceinte de test afin de soumettre des cartes électroniques connectées sur cette première partie du bus auxdites conditions de température ou de traitement, tandis que la seconde partie du bus est située hors de l'enceinte et à côté de celle-ci, pour soumettre des cartes électroniques connectées sur cette seconde partie du bus à d'autres conditions de température ou de traitement, mais dans les mêmes conditions électriques de fonctionnement.

Un tel dispositif a ainsi l'avantage de permettre de mettre en température séparément des cartes électroniques appartenant à l'une ou à l'autre partie du même bus électronique et travaillant ainsi dans les mêmes conditions électriques.

Selon un mode de réalisation préféré, les cartes électroniques connectées sur la seconde partie du bus sont des cartes d'instrumentation ou de test tandis que les cartes électroniques connectées sur la première partie du bus sont des cartes électroniques à tester.

En pratique, l'enceinte de test comprend une ouverture ménagée dans la paroi de l'enceinte et à travers laquelle est insérée la première partie du bus.

Avantageusement, le bus est destiné à être logé dans une baie électronique, et le bus est décalé hors de la baie d'une longueur correspondant à la longueur de la première partie du bus insérée dans l'enceinte.

Par exemple, les conditions de température de l'enceinte sont de -55°C à +125°C.

Avantageusement, le bus électronique est double face et l'enceinte comprend deux modules associés chacun à une face du bus et susceptibles chacun d'être soumis à des conditions spéciales respectives.

D'autres caractéristiques et avantages de l'invention apparaîtront à la lumière de la description détaillée ci-après et des dessins dans lesquels :
- la figure 1 illustre schématiquement un bus électronique double face et un châssis pour enceinte comprenant une ouverture ménagée dans une paroi du châssis et à travers laquelle est destinée à être insérée une partie du bus selon l'invention;
- la figure 2 illustre schématiquement l'insertion de la première partie du bus dans l'ouverture du châssis de l'enceinte selon l'invention;
- la figure 3 illustre schématiquement l'agencement de l'enceinte selon l'invention; et
- la figure 4 illustre schématiquement la baie électronique dans laquelle est logée la seconde partie du bus non insérée dans le châssis de l'enceinte selon l'invention.

La présente invention a pour objet un dispositif de test de cartes électroniques qui sont aptes à être connectées sur un bus électronique supportant des lignes électriques assurant la transmission de signaux de fonctionnement entre lesdites cartes électroniques.

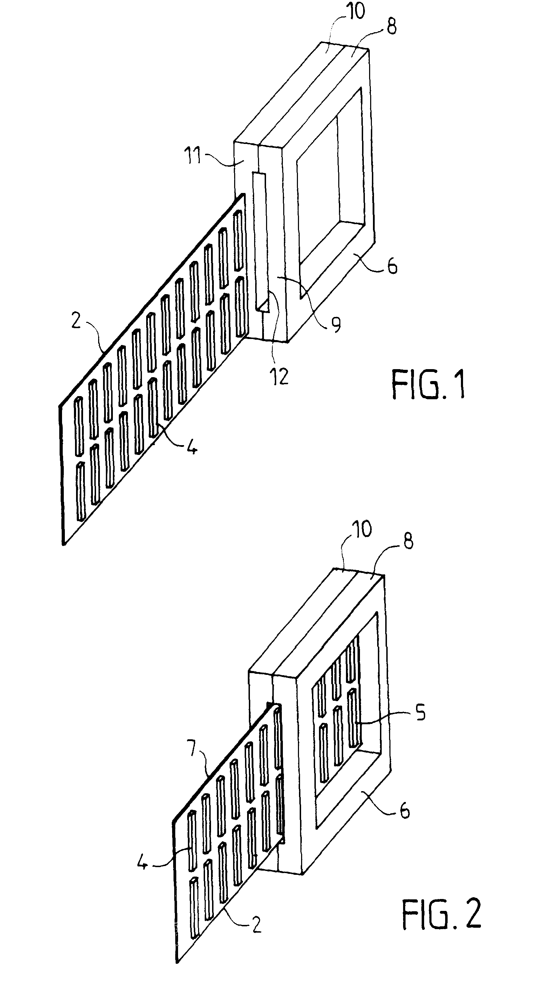

En référence à la figure 1, le bus électronique 2 est double face, avec sur chaque face par exemple une double rangée de connecteurs 4. Ce bus est de type quelconque. Par exemple, il est du type VME, VXI, ISA, EISA, PCI, etc. Il est réalisé sur un circuit imprimé en un matériau de type poly-imide ou époxy par exemple.

Selon l'invention, ce bus électronique est destiné à être inséré dans une structure ou châssis pour enceinte 6. Ce châssis 6 comprend deux cadres 8 et 10 superposés et de forme sensiblement rectangulaire. Une ouverture 12 est ménagée dans la face 9 du cadre 8 et la face 11 du cadre 10, les faces 9 et 11 étant adjacentes et juxtaposées. Cette ouverture 12 est de dimensions adaptées pour permettre l'insertion du bus aux dimensions normalisées.

En référence à la figure 2, une première partie 5 du bus 2 est insérée dans le châssis pour enceinte. Six connecteurs 4 sont disponibles sur chaque face du bus à l'intérieur du châssis pour enceinte.

La seconde partie 7 du bus, disposée hors de l'enceinte comprend ici 14 connecteurs disponibles sur chaque face du bus, et aptes à recevoir des cartes électroniques de test ou d'instrumentation comme nous le verrons plus en détail ci-après.

De leur côté, les six connecteurs de chaque face de la première partie 5 du bus sont destinés à recevoir des cartes électroniques à tester.

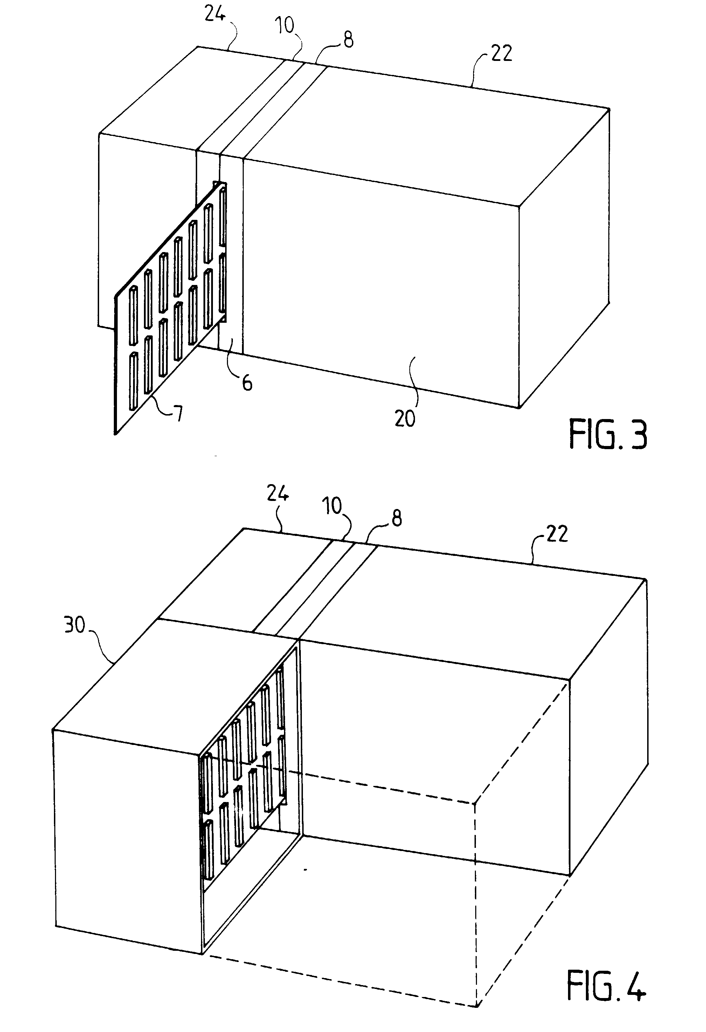

En référence à la figure 3, le châssis pour enceinte 6 supporte sur ses deux côtés une enceinte 20 à deux modules 22 et 24. Le module supérieur 22 a une hauteur adaptée pour permettre le logement de cartes électroniques à tester d'une hauteur standard et connectées sur une face du bus. Le module inférieur 24 a par exemple une hauteur plus faible que celle du module 22 pour permettre le logement à l'intérieur dudit module 24 de cartes électroniques de plus petite taille par exemple et connectées sur l'autre face du bus.

L'enceinte 20 est susceptible d'être soumise à des conditions spéciales de température ou de traitement avec des conditions particulières pour le module 22, et d'autres conditions particulières pour le module 24, le cas échéant. Par exemple, les températures peuvent être dans une plage allant de -55°C à +125°C avec par exemple -55°C dans le module 22, +80°C dans le module 24, et une température ambiante pour l'instrumentation.

Avantageusement, la seconde partie 7 du bus, située hors de l'enceinte et à côté de celle-ci, est logée dans une baie électronique 30.

Cette baie électronique 30 peut être une baie standard. Le bus est alors décalé hors de la baie d'une longueur correspondant à la longueur de la première partie 5 du bus insérée dans l'enceinte 20.

Grâce à l'invention, il est ainsi possible de soumettre des cartes électroniques à tester à des conditions spéciales de température et de traitement avec des cartes électroniques de test ou d'instrumentation non soumises à ces conditions spéciales mais travaillant dans les mêmes conditions électriques.

En pratique, les cadres 8 et 10 du châssis de l'enceinte sont réalisés en un matériau isolant thermiquement, par exemple une résine de verre telle que celle connue sous la dénomination "PERMAGLASS" associée à des mousses de type silicone à cellules ouvertes pour assurer l'étanchéité de l'enceinte.

En variante, des moyens d'isolation thermique complémentaires sont insérés dans le châssis pour enceinte pour permettre une meilleure isolation thermique. Par exemple, ces moyens d'isolation complémentaires comprennent un flux d'air sec destiné à rayonner dans les parois du châssis de l'enceinte.

Il est à remarquer que les signaux électroniques de fonctionnement sont véhiculés par les lignes électriques du bus électronique. Par contre, les signaux électriques d'alimentation peuvent être transmis par des câbles ou cordons d'alimentation entre les cartes électroniques situées dans l'enceinte et celles situées hors de l'enceinte. Il est à remarquer que ces signaux électriques d'alimentation ne sont pas critiques pour la qualité du test.

## Revendications

1. Dispositif de test de cartes électroniques dans des conditions de température ou de traitement choisies, lesdites cartes électroniques étant aptes à être connectées sur un bus électronique (2) supportant des lignes électriques pour la transmission de signaux de fonctionnement entre lesdites cartes électroniques, caractérisé en ce que le bus (2) comprend des première et seconde parties (5 et 7) fonctionnant selon des mêmes conditions électriques, la première partie (5) du bus étant d'une longueur choisie, et apte à être insérée dans une enceinte de test (8, 10, 20, 22, 24) afin de soumettre les cartes électroniques connectées sur cette première partie (5) du bus auxdites conditions de température ou de traitement, tandis que la seconde partie (7) du bus est située hors de l'enceinte et à côté de celle-ci, pour soumettre des cartes électroniques connectées sur cette seconde partie du bus à d'autres conditions de température ou de traitement, mais dans les mêmes conditions électriques de fonctionnement.

2. Dispositif selon la revendication 1, caractérisé en ce que les cartes électroniques connectées sur la seconde partie (7) du bus sont des cartes d'instrumentation de test tandis que les cartes électroniques connectées sur la première partie (5) du bus sont des cartes électroniques à tester.

3. Dispositif selon la revendication 1, caractérisé en ce que l'enceinte de test comprend une ouverture (12) ménagée dans une paroi de l'enceinte et à travers laquelle est insérée la première partie du bus.

4. Dispositif selon l'une quelconque des précédentes revendications, caractérisé en ce que le bus est destiné à être logé dans une baie électronique (30), et en ce que le bus est décalé hors de la baie électronique (30), d'une longueur correspondant à la longueur de la première partie (5) du bus inséré dans l'enceinte (20).

5. Dispositif selon l'une quelconque des précédentes revendications, caractérisé en ce que les conditions de température de l'enceinte sont de -55°C à +125°C.

6. Dispositif selon l'une quelconque des précédentes revendications, caractérisé en ce que le bus électronique (2) est double face et en ce que l'enceinte (20) comprend deux modules (22, 24) associés chacun à une face du bus (2) et susceptibles chacun d'être soumis à des conditions spéciales respectives.
